# EUROPEAN PATENT APPLICATION

(11) **EP 2 099 068 A1**
(43) Date of publication of application: **09.09.2009**
(21) Application number: 07851092.2
(22) Date of filing: 21.12.2007
(51) Int. Cl.: H01L 23/12, C04B 35/581, H01B 5/14, H01L 23/15

(54) **PROCESS FOR PRODUCING METALLIZED ALUMINUM NITRIDE SUBSTRATE**

(30) Priority: 28.12.2006 JP 2006353863
(71) Applicant: Tokuyama Corporation, Shunan-shi, Yamaguchi-ken 745-8648 (JP)
(72) Inventor: YAMAMOTO, Yasuyuki, Shunan-shi, Yamaguchi 745-8648 (JP); MAEDA, Masakatsu, Shunan-shi, Yamaguchi 745-8648 (JP); YATABE, Osamu, Shunan-shi, Yamaguchi 745-8648 (JP)
(74) Representative: Smart, Peter John
(86) International application number: PCT/JP2007/074740
(87) International publication number: WO 2008/081758

(57) **Abstract**

The present invention provides a method for manufacturing metallized aluminum nitride substrate, the method comprising: Step A for forming a high-melting point metal layer over a sintered aluminum nitride substrate; Step B for forming over the high-melting point metal layer an intermediate metal layer of at least one selected from the group consisting of: nickel, copper, copper-silver, copper-tin, and gold by plate processing; and Step C for forming a surface metal layer containing silver as a main component over the intermediate metal layer by coating a silver paste whose glass component content is 1 mass % or less and firing under nonoxidizing atmosphere. By this method, it is capable of forming a glass component-free silver layer which is adhered at a high degree of adhesion strength onto the high-melting point metal layer formed over the aluminum nitride substrate as a top face by thick-film method using a silver paste which makes thick-membrane forming easier.

## Description

### Technical Field

The present invention relates to a method for manufacturing a metallized aluminum nitride substrate which can be suitably used as a substrate for mounting semiconductor device of high power and also relates to a metallized aluminum nitride substrate manufactured by the method.

### Background Art

Recently, with downsizing, high-power, and high-density of the semiconductor devices, calorific power generated from the devices are increasing; this causes a problem of temperature increase of devices. When temperature of a device increases and goes beyond the acceptable degree, in case where the semiconductor device is a light-emitting diode (LED), shift of emission wavelength towards the longer wavelength side and extensive range of emission wavelength cause a decrease in device characteristic such as decrease in chroma and brightness. On the other hand, in case where the semiconductor device is a semiconductor device for electric power or a semiconductor device for integral circuit, the behavior becomes unstable, which is problematic. In order to inhibit temperature increase of the devices, it is necessary to diffuse heat by a radiator through the substrate. For this, as a substrate for mounting devices, a metallized aluminum nitride substrate which is obtained by forming a metal layer on the surface of a sintered aluminum nitride substrate of high thermal conductivity becomes popular.

As a method for manufacturing a metal layer over an aluminum nitride substrate, co-firing method (simultaneous firing method) and post-firing method (sequential firing method) both using a paste containing high-melting point metal powder such as tungsten and molybdenum are known. Co-firing method means a method to carry out sintering the aluminum nitride and adhering the high-melting point metal with heat simultaneously by coating a high-melting point metal paste over an aluminum nitride green tape and firing thereof. By this method, it is possible to form a solidly adhered metal layer; however, due to the shrinkage with sintering of the aluminum nitride, it is difficult to form a metal pattern at a high degree of precision. On the other hand, post-firing method means a method to carry out coating of a high-melting point metal paste on a pre-sintered aluminum nitride substrate and adhering thereof with heat; this method basically does not cause the above described problem regarding dimensional precision. Conventionally, by the post-firing method, to raise adhesion strength of the metal layer has thought to be hard; a post-firing method which is capable of forming a high-melting point metal layer adhered with a high degree of adhesion strength has also been developed (See Patent document 1.).

In addition, it is possible to form a metal layer over the aluminum nitride substrate using a metal paste other than the high-melting point metal paste; nevertheless, from the industrial point of view, it is hard to say that such an art has been established. For example, when a silver layer is directly formed over the aluminum nitride substrate using silver paste, there is a restriction such that not only a specific type of glass component must be mixed in the paste but also the substrate must include a specific type of additives. Even though a layer is formed by satisfying these conditions, adhesion strength between the obtained metal layer (membrane) and the substrate is lower than that of the one using a high-melting point metal paste (See Patent document 2.).

In order to surely form a metal layer which is adhered at a high degree of adhesion strength with low cost under a condition of less restriction to the substrate, as a thick-film method (particularly, the above co-firing method or the post-firing method) using a high-melting point metal paste is generally used as a metallization method of aluminum nitride, in the actual use, a method for forming other metal layers over a high-melting point metal layer formed by the method depending on the purpose is common. For instance, when used as a high-power wiring substrate, electric resistance of the wiring portion is preferably low so that a metal layer of high electric conductivity made of copper, gold, and silver is formed. With regard to the wiring substrate for mounting LED elements, so as to impart a function of efficiently reflecting the light emitted from LED to outside, as an upper-most metal layer, a silver layer of high-reflectance is formed onto the wiring portion (See Patent document 3.).

As a method for forming a silver layer over the high-melting point metal layer, a method for providing silver plating on the high-melting point metal layer (See Patent document 3.) is known. Alternatively, a method for adhering a silver paste with heat over the surface of the high-melting point metal layer may be considered.
Patent Document 1: WO 2006/051881
Patent Document 2: Japanese Patent Application Laid-Open (JP-A) No. 11-278941
Patent Document 3: JP-A No. 2004-207258

### Disclosure of the Invention

### Problems to be solved by the Invention

As shown in Patent document 3, providing a silver plating over the high-melting point metal layer has been widely carried out. However, when providing a thicker silver plating to lower the resistance of the metal layer, plating time becomes longer, which is problematic. Moreover, a method of electroless silver plating which provides a favorable plating membrane is not industrially established; therefore, electrolytic silver plating is normally adopted. Nevertheless, so as to perform electrolytic plating, it is necessary to draw the wiring for plating around; thereby downsizing of the wiring pattern is difficult.

On the other hand, when the silver paste is used, formation of thick-membrane is easy so that wiring for plating is not particularly required; however, when a silver paste containing a glass component is used, the electric resistance cannot be sufficiently reduced as it contains the glass component. Further, as a result of examination by the present inventors examined by using various silver paste including a glass component-free silver paste, in case where silver paste was directly coated over the high-melting point metal layer and fired thereof, there is a problem that a silver layer which is adhered to the high-melting point metal layer with sufficient adhesion strength cannot be formed.

Accordingly, an object of the present invention is to provide a method for manufacturing a metallized aluminum nitride substrate by forming, by thick-film method using an easily-thickened silver paste, a substantially glass component-free silver layer which is adhered at a high degree of adhesion strength over the high-melting point metal layer of aluminum nitride substrate produced by co-firing method or post-firing method using a high-melting point metal paste and having a high-melting point metal layer over the surface. In addition, the present invention provides a metallized aluminum nitride substrate manufactured by the method which is suitably used for a high-power wiring substrate as it is capable of minimizing the electric resistance of the metal layer as a wiring pattern, and the other metallized aluminum nitride substrate manufactured by the method which is suitably used for mounting LED elements since the surface of the metal layer is configured by a high-reflective silver.

### Means for Solving the Problems

The present inventors had seriously studied to solve the above problems. As a result, by providing an intermediate metal layer made of a specific metal over a high-melting point metal layer, the inventors discovered that a surface metal layer formed thereon can be solidly adhered by thick-film method using a substantially glass component-free silver paste; then, they completed the present invention as follows. It should be noted that in order to make the understanding of the present invention easier, reference numerals of the attached drawings are quoted in brackets; however, the present invention is not limited by the embodiment shown in the drawings.

The first aspect of the present invention is a method for manufacturing metallized aluminum nitride substrate (100), the method including: Step A for forming a high-melting point metal layer (20) over a sintered aluminum nitride substrate (10) ; Step B for forming, over the high-melting point metal layer (20), an intermediate metal layer (30) made of at least one selected from the group consisting of: nickel, copper, copper-silver, copper-tin, and gold by plate processing; and Step C for forming a surface metal layer (40) containing silver as a main component over the intermediate metal layer (30) by coating a silver paste whose glass component content is 1 mass % or less and firing thereof under nonoxidizing atmosphere.

The term "nonoxidizing atmosphere" in the Step C means, for example, a nonoxidizing gas atmosphere such as nitrogen and hydrogen; by firing under the condition, it is capable of inhibiting oxidation of the high-melting point metal layer (20) as the base material.

In addition, the term "main component" of "a surface metal layer containing silver as a main component" means the case which allows an embodiment where the surface metal layer (40) contains silver alloy and/or silver oxide. To the total mass of the surface metal layer (40) as 100 mass %, the silver content is 50 mass % or more, preferably 70 mass % or more, and more preferably 90 mass % or more.

The metal forming the intermediate metal layer (30), in addition to the above listed metals, may contain an additive component, such as phosphorus and/or boron.

In the first aspect of the invention, a thick-film method using a high-melting point metal paste, a plating method, and a thick-film method using a silver paste are sequentially carried out to form each of the metal layer. Because of this, the following effects can be obtained. In other words:
(1) by employing the thick-film method using a high-melting point metal paste, it is possible to solidify the adhesion between the sintered aluminum nitride substrate (10) and the high-melting point metal layer (20);
(2) by forming the intermediate metal layer (30) made of a specific metal by employing the plate processing, it is capable of securing solid adhesion between the intermediate metal layer (30) and the surface metal layer (40) formed thereon;
(3) since the surface metal layer (40) is formed by the thick-film method, control of film-thickness is easy and it does not take long before forming a thick film; and
(4) as the silver paste, the one, whose glass component content is extremely small, is used so that it is capable of lowing electric resistance of the surface metal layer (40).

In the first aspect of the invention, firing in the Step C is preferably carried out at a temperature between 450 degree C or more and less than the melting point of silver. When firing within the above temperature range, it is possible to inhibit collapse of pattern cross-section of the surface metal layer (40) and to favorably sinter the silver paste. Moreover, by firing within the temperature range, plating liquid saturated in the intermediate metal layer (30) during the plating step can be volatilized. Therefore, the plating liquid does not exude from the intermediate metal layer (30) of the metallized aluminum nitride substrate (100) obtained by the method.

In the first aspect of the invention, the silver paste to be used in the Step C contains silver particles whose surface may be oxidized and 10 to 100 mass % of which are preferably the one having average diameter of 1 nm to 800 nm. The silver particle composing the silver paste may be the one whose surface is oxidized or is not oxidized. The finer the particle becomes, the easier the surface oxidation becomes; however, even when containing particles whose surface is oxidized, these are reduced when firing. Hence, the oxidized silver particles can be used without any problems. Further, by containing a certain amount of the particles having the predetermined diameter, the firing temperature can be lowered. Still further, it is capable of inhibiting collapse of the wiring pattern that results in economically efficiency.

The first aspect of the present invention preferably further includes Step D, between the Step B and the Step C, for thermally treating the substrate, over which the intermediate metal layer (30) is formed, at a temperature of 700 degree C or more under nonoxidizing atmosphere. When the method further includes Step D, residual plating liquid in the intermediate metal layer (30) can be surely removed.

The second aspect of the present invention is a metallized aluminum nitride substrate (100) in which a metal layer is formed over a sintered aluminum nitride substrate (10), the metal layer having a laminated structure, in the order mentioned from the side of sintered aluminum nitride substrate (10), including: a high-melting point metal layer (20) ; an intermediate metal layer (30) made of at least one selected from the group consisting of: nickel, copper, copper-silver, copper-tin, and gold; and a surface metal layer (40) containing silver as a main component whose glass component content is 1 mass % or less.

In the second aspect of the invention, since the metal layer formed over the sintered substrate has the above described laminated structure, it is possible to solidify the adhesion between the respective neighboring layers. Adhesion strength between the respective neighboring metal layer is preferably 50 MPa or more.

The metallized aluminum nitride substrate (100) of the second aspect of the invention can be obtained by the method of the first aspect of the present invention; it is a substrate having a novel structure from the viewpoint that the metal layer having a specific layer structure is formed over the surface of the sintered aluminum nitride (10). By having such a layer structure, at least a part of the exposed surface of the metal layer is configured by a high-reflective silver so that the metallized aluminum nitride substrate (100) can be suitably used for package for LEDs. Moreover, by lowering the ratio of the high-melting point metal layer (20) within the area of the metal layer, this enables to lower the electric resistance of the metal layer; so, the metallized aluminum nitride substrate (100) of the invention can be suitably used as a high-power wiring substrate.

In the second aspect of the invention, a nickel-plated layer and/or a gold-plated layer are/is preferably formed at least a part of the surface of the surface metal layer (40). By providing such a layer, capability in wire bonding and soldering can be enhanced.

### Effects of the Invention

According to the first aspect of the present invention, it is capable of efficiently manufacturing the metallized aluminum nitride substrate (100) having a metal layer configured by a plurality of metal layers (20, 30, 40), where the upper-most layer (40) is formed by silver having high optical reflectance and high electric conductivity and the bottom surface of the metal layer is solidly adhered on the sintered aluminum nitride substrate (10). In addition, the method enables to form the surface metal layer (40) containing silver as a main component by thick-film method using a glass component-free silver paste or a silver paste containing extremely little glass component; therefore, by thickening the surface metal layer (40), it becomes possible to easily lower the electric resistance of the entire metal layer. Hence, the metallized aluminum nitride substrate (100) of the invention obtained by the method is useful as a high-power wiring substrate or a substrate (including packages and sub-mount) for mounting LEDs and/or LDs (laser diodes).

### Brief Description of the Drawings

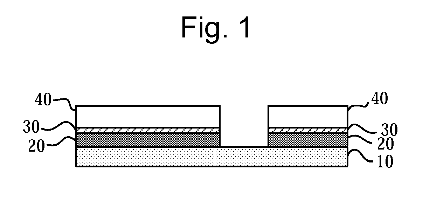

Fig. 1 is a schematic view showing a layer structure of metallized aluminum nitride substrate manufactured by the method of the present invention.

### Description of the Reference Numerals

- 10: sintered aluminum nitride substrate
- 20: high-melting point metal layer
- 30: intermediate metal layer
- 40: surface metal layer

### Best Mode for Carrying Out the Invention

Hereinafter, the present invention will be described with reference to the embodiment shown in the drawing.

### <Method for manufacturing metallized aluminum nitride substrate 100>

Fig. 1 is a schematic view showing a layer structure of metallized aluminum nitride substrate 100 manufactured by the method of the present invention. The method of the invention will be described by using the reference numerals in the drawing as follows. The method for manufacturing the metallized aluminum nitride substrate 100 includes: Step A for forming a high-melting point metal layer 20 over a sintered aluminum nitride substrate 10; Step B for forming, over the high-melting point metal layer 20, an intermediate metal layer 30 by plate processing; and Step C for forming a surface metal layer 40 containing silver as a main component over the intermediate metal layer 30 by coating a silver paste and firing thereof. Each steps will be described as follows.

### (Step A for forming the high-melting point metal layer 20)

In the manufacturing method of the invention, first of all, the high-melting point metal layer 20 is formed over the sintered aluminum nitride substrate 10. The sintered aluminum nitride substrate 10 can be produced by a known method by firing a predetermined shape of aluminum nitride green tape or a pressed compact formed by pressing the aluminum nitride granule. The shape and thickness are not specifically restricted to. As ingredient of a sintered body, sintering aids like conventionally used rare earthes may be contained. As required, the surface of the sintered aluminum nitride substrate 10 may be polished.

As a method for forming the high-melting point metal layer 20 over the sintered aluminum nitride substrate 10, there are two methods: the first method is the one (co-firing method) by firstly coating the high-melting point metal paste over the surface of the green tape or the pressed compact, and then, firing the high-melting point metal paste and the green tape or the pressed compact at the same time; and the second method is the one (post-firing method) by firstly coating the high-melting point metal paste over the pre-fired sintered aluminum nitride 10, and then, firing the high-melting point metal paste. With regard to the co-firing method, the high-melting point metal layer is also fired when firing the substrate so that deformation is caused due to the shrinkage; thereby even when the surface metal layer is attempted to be successfully superposed thereon, it is difficult to superpose them due to the defects of the high-melting point metal layer. So, in the invention, the high-melting point metal layer 20 is preferably formed by post-firing method.

In the post-firing method, at a predetermined position for forming surface wiring patterns of the sintered aluminum nitride substrate 10, the high-melting point metal paste is coated. The high-melting point metal paste is preferably configured with high-melting point metal particles, binder, and solvent; particularly, preferably, it does not contain glass component and oxide. When the high-melting point metal paste contains glass component and the like, depending on the firing condition of the silver paste in the post-process, the glass component is sometimes melted and comes to the surface; whereby adhesion between the neighboring metal layers may be inferior. Examples of the high-melting point metal can include tungsten or molybdenum.

The average particle diameter of the high-melting point metal is preferably 1 µm to 5 µm, more preferably 2 µm to 5 µm. By anchor effect, in order to enhance adhesion strength with the intermediate metal layer 30, particle diameter of the high-melting point metal is preferably larger; in view of sintering performance of the high-melting point metal, particle diameter of the high-melting point is preferably smaller. By considering the balance between these, the above range has been determined. It should be noted that, in the invention, average diameter of the high-melting point metal powder is determined by air permeability method using Fisher's "Sub-Sieve Sizer".

In addition, in order to enhance the adhesion strength with the sintered aluminum nitride substrate 10, aluminum nitride powder is preferably added to the high-melting point metal paste. Particularly, adding aluminum nitride powder is preferable, because that provides a structure where the high-melting point metal and the aluminum nitride are intertwined with in a complex form at a time of firing, anchor effect can be developed by making the aluminum nitride powder in the high-melting point metal paste bond to the aluminum nitride in the sintered aluminum nitride substrate 10, and high adhesion strength can be obtained.

Therefore, the average diameter of the aluminum nitride powder to be added (i.e. 0.5 µm to 2 µm) is preferably smaller than that of the high-melting point metal powder as it tends to bond to aluminum nitride of the sintered aluminum nitride substrate 10. It should be noted that, in the present invention, the average diameter of the aluminum nitride particle is the volume average particle diameter determined by laser diffractometry.

Coating of the high-melting point metal paste is preferably carried out by printing in view of formation of precision wiring. As the printing, screen printing, ink-jet printing, offset printing and so on may be employed.

The high-melting point metal paste coated over the sintered aluminum nitride substrate 10 is fired normally at a temperature between 1700 degree C and 1900 degree C under nonoxidizing atmosphere (post-firing method). By employing the post-firing method to form the high-melting point metal layer 20 in this way, shrinkage of the high-melting point metal paste is inhibited; while, by using particles having larger diameter as a high-melting point metal, compared with a material where a ceramic green tape and a high-melting point metal paste are fired simultaneously (products of the co-firing method), the produced high-melting point metal layer 20 becomes configured by a structure having a large number of voids. The term "under nonoxidizing atmosphere" of the firing conditions means, for example, atmosphere of inert gases (e.g. nitrogen) or nonoxidizing gas of hydrogen and so on. These nonoxidizing gases may contain carbon vapor and/or carbon monoxide.

Thickness of the high-melting point metal layer 20 is preferably 1 µm to 15 µm. When the thickness is too thin, an object to form the surface metal layer 40 over the sintered aluminum nitride substrate 10 at a high degree of adhesion strength cannot be attained. On the other hand, when the thickness is too thick, since it is necessary to secure a certain thickness of the surface metal layer 40 to make a low-resistant wiring pattern, consequently thickness of the total metal layer needs to be thicker; thereby a problem in space is caused. Moreover, as thickness of the high-melting point metal layer 20 is shrunk to about 60% to 90% by sintering, so as to set the thickness of the wiring pattern 20 made of the high-melting point metal within the above range, thickness of the high-melting point metal paste is preferably 3 µm to 25 µm.

### (Step B for forming the intermediate metal layer 30 by plate processing)

In order to improve adhesion strength between the above-described high-melting point metal layer 20 and the below-described surface metal layer 40, in the present invention, the intermediate metal layer 30 is preferably formed over the high-melting point metal layer 20 by plate processing. Examples of the intermediate metal layer 30 include: nickel plating, copper plating, copper-silver plating, copper-tin plating, gold plating, or plating of alloy of these metals. These plating is not expensive, it is favorable in adhesion with the surface metal layer 40 formed in the post-process and with the high-melting point metal layer 20. In the intermediate metal layer 30, in addition to the above metals, additive components such as phosphorus and boron may be contained. Further, plating method is not specifically restricted; it may be a known electrolytic plating or electroless plating. Still further, in case where firing (adhesion) temperature of the surface metal layer 40 is set within the range of 600 degree C or more and electroless plating is employed, Ni-B plating is more preferable as it can be easily diffused in the high-melting point metal.

Hence, by forming the intermediate metal layer 30 and carrying out firing of the below-described surface metal layer 40, diffusion between the respective neighboring metal layers is caused; thereby it is thought that the high-melting point metal layer 20 and the intermediate metal layer 30 as well as the intermediate metal layer 30 and the surface metal layer 40 are solidly adhered, accordingly inter-layer adhesion strength is increased.

Moreover, in the Step B, plating process is performed; however, because residual plating liquid is splashed at the time of firing in the Step C, a problem in exudation of residual plating liquid from the produced metallized aluminum nitride substrate 100 is hard to be caused. In addition, for the purpose of surely eliminate retention of the plating liquid, after the Step B, Step D for thermally treating the substrate in which the intermediate metal layer 30 is formed may be carried out in a nonoxidizing atmosphere at a temperature of 700 degree C or more. Here, the term "nonoxidizing atmosphere" is the same meaning as "nonoxidizing atmosphere of firing the high-melting point metal paste".

Thickness of the intermediate metal layer 30 is preferably 0.05 µm or more. By setting the thickness of the intermediate metal layer 30 within the range of 0.05 µm or more, it is capable of enhancing adhesion strength with the high-melting point metal layer 20 and with the surface metal layer 40. Moreover, upper limit of the thickness of the intermediate metal layer 30 is not particularly limited to; when the intermediate metal layer 30 is formed by plating, in view of economic efficiency, 10.0 µm is preferable.

### (Step C for forming the surface metal layer 40)

Over the intermediate metal layer 30 produced as above, a silver paste whose glass component content is 1 mass % or less is coated, and the resultant is fired under nonoxidizing atmosphere to form a surface metal layer 40 containing silver as a main component (Step C). Coating of the silver paste, in view of formation of precision wiring, is preferably performed by printing. Examples of printing may include: screen printing, ink-jet printing, and offset printing.

The silver paste includes silver particles, a binder, and a solvent. The silver particles are silver or silver alloy particle. The silver alloy means the one containing, to 100 parts by mass of silver, below 100 parts by mass of a metal element other than silver; for instance, silver-copper alloy can be the example.

Further, the silver particles may be silver particles whose surface is oxidized. To the total mass of the silver particles as 100 mass %, 10 mass % to 100 mass % of the silver particle is preferably silver microparticles having average diameter of 1 nm to 800 nm. Accordingly, firing temperature can be lowered and high-precision wiring pattern can be formed without causing collapse of the wiring pattern of the surface metal layer 40 by heating at the time of firing. Average diameter of the silver particles other than the silver microparticles is preferably 0.5 µm to 10 µm. In the invention, average diameter of the silver particle (silver microparticle and silver particle) is the volume-average particle diameter determined by laser diffractometry.

Glass component content in the silver paste is preferably 1 mass % or less. By using the silver paste having little glass component in this way, absence of insulating glass component in the finally formed surface metal layer 40 makes it possible to lower the resistance of the surface metal layer 40. In addition, wire bonding to the surface of the surface metal layer 40 also becomes easier.

The glass component means: silicon oxide, aluminum oxide, boron oxide, lead oxide, copper oxide, zinc oxide, rare-earth oxide, 1A group oxide, and 2A group oxide. The reason for setting the glass component content to 1 mass % or less is because there is a case where glass component is contained as impurities though the glass component is not added deliberately, the above range is provided to allow such a circumstance.

The surface metal layer 40 of the invention is a metal layer having grain boundary and/or voids. Such a metal layer can be obtained by firing silver particles but cannot be obtained by plating. As the invention includes the surface metal layer 40 having this structure, there is no problem of liquid retention in the metal membrane and exude of the liquid therefrom over time.

The coated silver paste is fired under nonoxidizing atmosphere. For instance, when fired under atmosphere, high-melting point metal or plated membrane as the base is oxidized so that adhesive force is deteriorated. The term "under nonoxidizing atmosphere" means under atmosphere of nonoxidizing gas such as nitrogen and hydrogen; by firing under the atmosphere, it is capable of inhibiting oxidation of the high-melting point metal layer 20 as the base. Moreover, when firing is carried out under nitrogen-hydrogen atmosphere or hydrogen atmosphere containing water-vapor or water, binder component contained in the paste becomes easily decomposed; consequently, the silver paste becomes easily sintered, thereby it is preferable. Further, when the silver paste contains silver particles whose surface is oxidized, in view of feasibility in reduction of oxidative product, as the nonoxidizing atmosphere, reductive gas atmosphere like nitrogen gas or hydrogen gas respectively containing carbon or carbon monoxide is preferably adopted.

The firing is preferably performed at a temperature of below melting point of silver (961 degree C) since a precise pattern can be formed without collapsing pattern cross-section of the surface metal layer 40; thus it is preferable. Because of this, firing temperature is preferably as low as possible; in consideration of sintering performance of the silver paste, lower limit of the firing temperature is preferably 450 degree C or more and more preferably 600 degree C or more. Further, when forming an intermediate metal layer 30 containing nickel as a base of the surface metal layer 40, firing temperature for improving adhesiveness between the intermediate metal layer 30 and the high-melting point metal layer 20 is more preferably 600 degree C or more. On the other hand, upper limit of the firing temperature is preferably 960 degree C or less, more preferably 950 degree C or less.

Thus, in the manufacturing method of the wiring substrate of the present invention, firing is preferably carried out at a temperature of below melting point of silver as a material of wiring. Accordingly, it is capable of solving the problem such that the surface metal layer 40 is collapsed by melting at a time of firing and thereby it prevents forming a precision wiring.

Thickness of the surface metal layer 40 is adequately determined depending on the application; it is preferably 1 to 100 µm, more preferably 5 to 100 µm. When thickness of the surface metal layer 40 meets within the range, it is capable of forming a low-resistant wiring pattern and the obtained substrate can be used for various applications. Thickness of the layer is shrunk to about 60% to 90% by sintering so that the silver paste layer may be formed in consideration of the shrinkage.

The surface metal layer 40 containing silver as the main component is difficult to be oxidized; therefore, it has features that there is no need to give plating over the surface and wire bonding and soldering can be performed in a state being just as it is. Moreover, a laminated structure where silver paste is further coated over the above described silver-copper alloy paste may be adopted. As seen above, when the silver-copper paste layer is laminated, thereafter, silver paste layers are continuously laminated thereon and adhered with heat, it is possible to enhance adhesive force between the metal layers. As required, surface of the surface metal layer 40 can be smoothed by polishing or the like. As a consequence, mountability of the semiconductor device can be favorable.

When plating is necessary, various kind of plating can be given depending on the character of the substrate. For example, if the surface is required to be coated by gold, nickel-plated layer and gold-plated layer may be sequentially formed on the surface of the surface metal layer 40. Moreover, silver and gold are favorably adhered so that gold plating may be directly given over the surface metal layer 40. Plating method is not specifically restricted to; since known methods can be used, conventional electrolytic plating or electroless plating can be employed. These can be used depending on the wiring. In addition, methods such as oscillatory plate, barrel plating, spray plating can be adopted. As required, partial plating can be carried out by coating with resist and/or tape a part where plating is not wanted, plating thereafter, and then removing the resist and/or tape.

Adhesion strength between the metal layers 20 and 30 as well as the metal layers 30 and 40 thus obtained is preferably 50 MPa or more, more preferably 80 MPa or more, and further more preferably 100 MPa or more. An example of the method for measuring the adhesion strength is as follows; by using a nickel-plated 42 alloy nail headpin having diameter of 1.1 mm, the nail headpin is soldered with soldering material such as Pb-Sn solder on the surface of the surface metal layer 40 and the nail headpin is pulled in the vertical upper direction at a rate of 10 mm/min. The strength at a time when the nail headpin is come off is determined as the adhesion strength (MPa) by interlayer fracture of either of the respective neighboring metal layers 20, 30, and 40 or solder layer for adhering nail headpin when pulled, or by interfacial fracture between the base layer and any one of these layers when pulled.

Resistance of the respective metal layers 20, 30, 40 is preferably 2 mΩ or less, more preferably 1 mΩ or less, and further more preferably 0.5 mΩ or less. Resistance of the metal layer was determined by four probes method.

### Examples

Hereinafter, the present invention will be described by way of examples; however, the present invention is not limited by these examples.

### (Example 1)

Aluminum nitride powder having average diameter of 1.5 µm and yttrium oxide as sintering aids were added and sintered thereafter to obtain a raw substrate made of the sintered aluminum nitride substrate. One hundred parts by mass of tungsten having average diameter of 2.1 µm, 4 parts by mass of aluminum nitride powder having average diameter of 1.5 µm, 2 parts by mass of ethylcellulose, 13 parts by mass of terpineol, and 1 part by mass of dispersant were kneaded to produce a high-melting point metal paste whose viscosity at 25 degree C was adjusted to 80 Pa·s. Later, by screen printing method using the paste, total twenty-five (five each in lengthwise and crosswise) 2 mm square patterns were formed at intervals of 100 µm over the surface of raw substrate and dried at 100 degree C for 5 minutes. The film-thickness after drying was 13 µm.

The substrate thus obtained was fired under nitrogen gas at 1750 degree C for 4 hours and aluminum nitride sintering substrate having the high-melting point metal wiring pattern was obtained. Thickness of the post-fired high-melting point metal wiring pattern was 10 µm. Thereafter, 0.2 µm-thick electroless Ni-B plating was given over the high-melting point metal wiring pattern to form an intermediate metal layer.

Then, 100 parts by mass of silver having average particle diameter of 500 nm, 2 parts by mass of ethylcellulose, 12 parts by mass of terpineol, and 1 part by mass of dispersant were kneaded and silver paste having viscosity at 25 degree C of 30 Pa·s was prepared. Later, the silver paste was recoated over the above described intermediate metal layer and the coating was dried at 100 degree C for 5 minutes. Thickness of the silver paste after drying was 20µm. After that, the silver paste was fired under hydrogen atmosphere at 950 degree C for 0.5 hours to form a surface metal layer. Thickness of the wiring portion (the entire metal layer) after firing was 25 µm.

When adhesive force (adhesion strength) of the metal layers (wiring pattern) about the metallized aluminum nitride substrate thus obtained was measured, it was 99 MPa; the destroyed mode (a location where peeling happens) was internal solder. Measuring of the adhesion strength was carried out by soldering with Pb-Sn solder a nickel-plated 42 alloy nail headpin having diameter of 1.1 mm on the surface metal layer and thereafter by tensile test for pulling the nail headpin in the vertical upper direction at a rate of 10 mm/min (Same tensile test was repeated for five times and the average of the results is shown in Table 1.). Moreover, when resistance of 2 mm square wiring pattern was measured by four probes method, it was 0.3 mΩ.

### (Example 2)

Except for using a silver paste containing 50 parts by mass of silver having average particle diameter of 500 nm and 50 parts by mass of silver having average particle diameter of 3 µm instead of using 100 parts by mass of silver having average particle diameter of 500 nm and except for setting the firing temperature of the silver paste as shown in Table 1, Example 2 was carried out in the same manner as Example 1 to manufacture the metallized aluminum nitride substrate. When adhesion strength of the metal layer of the obtained substrate was measured, adhesion strength was 106 MPa and the destroyed mode was internal solder. Moreover, when resistance of the 2 mm square wiring patter was measured by four probes method, it was 0.3 mΩ.
It should be noted that, in the following Examples and Comparative examples, some of the thickness of the plating (thickness of the intermediate metal layer) were changed; by adjusting the level of recoating of the silver paste, thickness of these wiring portions (entire metal layer) after firing were made to be 25 µm.

### (Examples 3 to 10)

Except for changing kinds and thickness of electroless plating or changing the firing temperature of the silver paste as shown in Table 1, Examples 3 to 10 were carried out in the same manner as Example 2 to manufacture the metallized aluminum nitride substrate. The adhesion strength of the metal layers of the obtained substrate and resistance of the 2 mm square wiring pattern were measured. The results are shown in Table 1.

### (Examples 11 to 13)

Except for using a multi-layered plated layer using two types of electroless plating as shown in Table 1 for forming the intermediate metal layer, Examples 11 to 13 were carried out in the same manner as Example 2 to manufacture the metallized aluminum nitride substrate. Adhesion strength of the metal layers of the obtained substrate and resistance of 2 mm square wiring pattern were measured. The results are shown in Table 1. It should be noted that order of plating is that: for example, in Example 11, firstly, a copper plating was given over tungsten, and then a silver plating was given thereon. In other words, metals shown in leftmost of Table 1 was plated over tungsten, thereafter metal shown in upper-right of Table 1 was plated (same in the following Example).

### (Example 14)

Except for changing the temperature of firing the silver paste to 500 degree C, Example 14 was carried out in the same manner as Example 2 to manufacture the metalized aluminum nitride substrate. Then, adhesion strength of the metal layers of the obtained substrate and resistance of 2 mm square wiring pattern were measured. The results are shown in Table 1. The destroyed mode was internal solder and partly tungsten-Ni plating interlayer.

### (Example 15)

Except for forming the intermediate metal layer by giving 0.6 µm thick electroless copper plating over tungsten and giving 0.5 µm thick electroless silver plating thereon, and except for changing temperature of firing (adhesion) the silver plate to 500 degree C, Example 15 was carried out in the same manner as Example 11 to manufacture the metallized aluminum nitride substrate. Then, adhesion strength of the metal layers of the obtained substrate and resistance of 2 mm square wiring pattern were measured. The results are shown in Table 1. The destroyed mode was internal solder and partly the tungsten-copper plating interlayer.

### (Examples 16 to 27)

Except for performing thermal treatment under hydrogen gas atmosphere at a temperature shown in Table 1 for 0.5 hours after plating (after forming of intermediate metal layer) and thereafter coating and firing the silver paste thereon, Examples 16 to 27 were carried out in the same manner as Examples 2-13 to manufacture the metallized aluminum nitride substrate. Then, adhesion strength of the metal layers of the obtained substrate and resistance of 2 mm square wiring pattern were measured. The results are shown in Table 1.

### (Example 28)

Except for firing the silver paste under atmosphere of mixture of nitrogen gas and hydrogen gas (mixing ratio = 70:30), Example 28 was carried out in the same manner as Example 2 to manufacture the metallized aluminum nitride substrate. Then, adhesion strength of the metal layers of the obtained substrate and resistance of 2 mm square wiring pattern were measured. The results are shown in Table 1.

### (Comparative example 1)

Except for directly (without giving Ni-B plating) coating the silver paste over the high-melting point metal layer and firing thereafter, Comparative example 1 was carried out in the same manner as Example 2 to manufacture the metallized aluminum nitride substrate. Then, adhesion strength of the metal layers of the obtained substrate and resistance of 2 mm square wiring pattern were measured. The results are shown in Table 1. Since the metallized aluminum nitride substrate of Comparative example 1 did not form an intermediate metal layer, adhesion strength became 27 MPa, which was low. The destroyed mode was the tungsten-silver interlayer as well as partly between tungsten and solder.

### (Comparative example 2)

Except for giving 0.6 µm thick electrolytic silver plating over tungsten instead of Ni-B plating, Comparative example 2 was carried out in the same manner as Example 2 to manufacture the metallized aluminum nitride substrate. Then, adhesion strength of the metal layers of the obtained substrate and resistance of 2 mm square wiring pattern were measured. The results are shown in Table 1. The destroyed mode was tungsten-silver interlayer as well as partly between tungsten and solder. As metal of the intermediate metal layer was different (silver) from the one specified in the present invention, adhesion strength became 24 MPa, which was low.

### (Comparative example 3)

Except for not forming the intermediate metal layer but directly coating, over the high-melting point metal layer, a silver paste which was obtained by kneading 100 parts by mass of silver having average particle diameter of 500 nm, 2 parts by mass of ethylcellulose, 13 parts by mass of terpineol, 1 part by mass of dispersant, and 10 parts by mass of glass containing boric acid and silica and by adjusting the viscosity at 25 degree C to 35 Pa·s, and except for changing the temperature for firing the silver paste to the temperature as shown in Table 1, Comparative example 3 was carried out in the same manner as Example 1 to manufacture the metallized aluminum nitride substrate. Thickness after drying of the silver paste (at 100 degree C for 5 minutes) was 20µm and thickness of the wiring portion after firing was 25 µm. Then, adhesion strength of the metal layers of the obtained substrate and resistance of 2 mm square wiring pattern were measured. The results are shown in Table 1. Since the intermediate metal layer was not formed on the metallized aluminum nitride substrate, adhesion strength became 15 MPa, which is low; since surface metal layer contains glass component, despite the thick silver layer, the resistance was 1.5 mΩ, which was high. The destroyed mode was internal silver layer as well as between solder and tungsten.

### (Comparative example 4)

Except for firing the silver paste under atmosphere at a temperature of 600 degree C for 0.5 hours, Comparative example 4 was carried out in the same manner as Example 2 to manufacture the metallized aluminum nitride substrate. Then, adhesion strength of the metal layers of the obtained substrate and resistance of 2 mm square wiring pattern were measured. The results are shown in Table 1. Since firing of the silver paste was performed under oxidizing atmosphere, surface of the tungsten metallized layer or plated layer was oxidized before the start of sintering of silver; therefore adhesiveness with silver was decreased, thereby it is thought that adhesion strength was not raised.

(Table 1)

**(Table 1)**

| No. | Plating on High-melting point Metal | Plating thickness (µm) | Thermal treatment after Plating | Silver particle diameter and Parts By Mass in Silver paste | | Glass component in Silver paste | Firing temperature of Silver paste | Firing atmosphere of Silver paste | Adhesion strength (Ave) MPa | Resistance (mΩ) |
|---|---|---|---|---|---|---|---|---|---|---|
| | | | | 0.5 µm | 3 µm | | | | | |
| Example 1 | Ni-B | 0.2 | - | 100 | | None | 950°C | H₂ | 99 | 0.3 |
| Example 2 | Ni-B | 0.2 | - | 50 | 50 | None | 910°C | H₂ | 106 | 0.3 |
| Example 3 | Ni-B | 0.7 | - | 50 | 50 | None | 910°C | H₂ | 100 | 0.4 |
| Example 4 | Ni-B | 1 | - | 50 | 50 | None | 950°C | H₂ | 98 | 0.5 |
| Example 5 | Ni-P | 0.1 | - | 50 | 50 | None | 910°C | H₂ | 106 | 0.3 |
| Example 6 | Ni-P | 0.6 | - | 50 | 50 | None | 910°C | H₂ | 104 | 0.4 |
| Example 7 | Cu | 0.2 | - | 50 | 50 | None | 910°C | H₂ | 110 | 0.3 |
| Example 8 | Cu | 0.5 | - | 50 | 50 | None | 910°C | H₂ | 110 | 0.3 |
| Example 9 | Au | 0.2 | - | 50 | 50 | None | 910°C | H₂ | 84 | 0.6 |
| Example 10 | Au | 0.6 | - | 50 | 50 | None | 910°C | H₂ | 90 | 0.6 |
| Example 11 | Cu/Ag | 0.6/0.1 | - | 50 | 50 | None | 910°C | H₂ | 116 | 0.3 |
| Example 12 | Cu/Sn | 0.1/0.1 | - | 50 | 50 | None | 910°C | H₂ | 112 | 0.9 |
| Example 13 | Cu/Sn | 0.6/0.5 | - | 50 | 50 | None | 910°C | H₂ | 116 | 1.6 |
| Example 14 | Ni-B | 0.2 | - | 50 | 50 | None | 500°C | H₂ | 72 | 0.3 |
| Example 15 | Cu/Ag | 0.6/0.5 | - | 50 | 50 | None | 500°C | H₂ | 55 | 0.2 |
| Example 16 | Ni-B | 0.2 | 850°C | 50 | 50 | None | 910°C | H₂ | 102 | 0.3 |
| Example 17 | Ni-B | 0.7 | 850°C | 50 | 50 | None | 910°C | H₂ | 110 | 0.3 |
| Example 18 | Ni-B | 1 | 910°C | 50 | 50 | None | 950°C | H₂ | 105 | 0.4 |
| Example 19 | Ni-P | 0.1 | 850°C | 50 | 50 | None | 910°C | H₂ | 110 | 0.3 |
| Example 20 | Ni-P | 0.6 | 850°C | 50 | 50 | None | 910°C | H₂ | 106 | 0.4 |
| Example 21 | Cu | 0.2 | 850°C | 50 | 50 | None | 910°C | H₂ | 109 | 0.2 |
| Example 22 | Cu | 0.5 | 850°C | 50 | 50 | None | 910°C | H₂ | 118 | 0.3 |
| Example 23 | Au | 0.2 | 850°C | 50 | 50 | None | 910°C | H₂ | 96 | 0.6 |
| Example 24 | Au | 0.6 | 850°C | 50 | 50 | None | 910°C | H₂ | 94 | 0.8 |
| Example 25 | Cu/Ag | 0.6/0.1 | 850°C | 50 | 50 | None | 910°C | H₂ | 112 | 0.3 |
| Example 26 | Cu/Sn | 0.1/0.1 | 850°C | 50 | 50 | None | 910°C | H₂ | 113 | 0.8 |
| Example 27 | Cu/Sn | 0.6/0.5 | 850°C | 50 | 50 | None | 910°C | H₂ | 111 | 1.6 |
| Example 28 | Ni-B | 0.2 | - | 50 | 50 | None | 910°C | N₂-H₂ | 95 | 0.3 |
| Comparative example 1 | - | - | - | 50 | 50 | None | 910°C | H₂ | 27 | 0.6 |
| Comparative example 2 | Ag | 0.6 | - | 50 | 50 | None | 910°C | H₂ | 24 | 0.6 |
| Comparative example 3 | - | - | - | 100 | - | Included | 910°C | H₂ | 15 | 1.5 |
| Comparative example 4 | Ni-B | 0.2 | - | 50 | 50 | None | 600°C | Atmosphere | 45 | 0.4 |

The above has described the present invention associated with the most practical and preferred embodiments thereof. However, the invention is not limited to the embodiments disclosed in the specification. Thus, the invention can be appropriately varied as long as the variation is not contrary to the subject substance and conception of the invention which can be read out from the claims and the whole contents of the specification. It should be understood that method for manufacturing metallized aluminum nitride substrate and the obtained metallized aluminum nitride substrate with such an alternation are included in the technical scope of the invention.

### Industrial Applicability

The metallized aluminum nitride substrate manufactured by the method of the present invention is useful for a high-power wiring substrate or a substrate for mounting LEDs and/or LDs (including package and sub-mount).

## Claims

1. A method for manufacturing metallized aluminum nitride substrate, the method comprising:
Step A for forming a high-melting point metal layer over a sintered aluminum nitride substrate;
Step B for forming, over the high-melting point metal layer, an intermediate metal layer of at least one selected from the group consisting of: nickel, copper, copper-silver, copper-tin, and gold by plate processing; and
Step C for forming a surface metal layer containing silver as a main component over the intermediate metal layer by coating a silver paste whose glass component content is 1 mass % or less and firing thereof under nonoxidizing atmosphere.

2. The method for manufacturing a metallized aluminum nitride substrate according to claim 1, wherein firing in the Step C is carried out at a temperature between 450 degree C or more and less than the melting point of silver.

3. The method for manufacturing a metallized aluminum nitride substrate according to claim 1 or 2, wherein the silver paste to be used in the Step C contains silver particles whose surface may be oxidized and 10 to 100 mass % of which are the one having average diameter of 1 nm to 800 nm.

4. The method for manufacturing a metallized aluminum nitride substrate according to any one of claims 1 to 3 further comprising Step D, between the Step B and the Step C, for thermally treating the substrate, over which the intermediate metal layer is formed, at a temperature of 700 degree C or more under nonoxidizing atmosphere.

5. A metallized aluminum nitride substrate in which a metal layer is formed over a sintered aluminum nitride substrate, the metal layer having a laminated structure, in the order mentioned from the side of sintered aluminum nitride substrate, comprising:
a high-melting point metal layer;
an intermediate metal layer made of at least one selected from the group consisting of: nickel, copper, copper-silver, copper-tin, and gold; and
a surface metal layer containing silver as a main component whose glass component content is 1 mass % or less.

6. The metallized aluminum nitride substrate according to claim 5, wherein adhesion strength between the respective neighboring metal layer is 50 MPa or more.

7. The metallized aluminum nitride substrate according to claim 5 or 6, wherein a nickel-plated layer and/or a gold-plated layer are/is formed at least a part of the surface of the surface metal layer.
